# EUROPEAN PATENT APPLICATION

(11) **EP 4 783 811 A2**
(43) Date of publication of application: **29.07.2026**
(21) Application number: 26153562.9
(22) Date of filing: 22.01.2026
(51) Int. Cl.: H10P 72/00

(54) **TEMPERATURE CONTROL APPARATUS, TEMPERATURE CONTROL METHOD, TEMPERATURE CONTROL PROGRAM, AND WAFER MANUFACTURING APPARATUS**

(30) Priority: 27.01.2025 JP 2025011719
(71) Applicant: Epicrew Corporation, Ohmura-shi, Nagasaki 856-0022 (JP)
(72) Inventor: OKABE, Akira, Nagasaki, 8560022 (JP); YAMAOKA, Tomonori, Nagasaki, 8560022 (JP); TAKEUCHI, Atsuki, Nagasaki, 8560022 (JP)
(74) Representative: AWA Sweden AB

(57) **Abstract**

A temperature control apparatus (1) comprising: a chamber (11) for housing an object to be measured; heating units (25, 26, 27, 28); a chamber window unit (18) positioned opposite the object to be measured; a central temperature measurement unit (21) for measuring a temperature of a central portion (14c) of the object to be measured; a peripheral temperature measurement unit (22) for measuring a temperature of a peripheral portion (14e) of the object to be measured; an identification unit (30) provided in the peripheral temperature measurement unit (22) for identifying a position of the peripheral portion (14e) of the object to be measured; an adjustment unit (110) that adjusts a measurement direction of the peripheral temperature measurement unit (22), a calculation unit (120) that calculates the central temperature and peripheral temperature, and an output control unit (130) that controls outputs of the plurality of heating units (25, 26, 27, 28) based on both the central temperature and peripheral temperature is provided.

## Description

### BACKGROUND OF THE INVENTION

### 1. Technical Field

The present invention relates to a temperature control apparatus, a temperature control method, a temperature control program, and a wafer manufacturing apparatus. Specifically, it relates to a temperature control apparatus that indirectly measures a temperature of each part of an object to be measured and controls heating conditions, and a method thereof and a program thereof, and also relates to a wafer manufacturing apparatus including the temperature control apparatus.

### 2. Description of Related Art

In the manufacture of silicon wafers, which are components of semiconductors, epitaxial growth apparatus is currently widely used. In this apparatus, a silicon wafer is housed within a chamber, and a temperature of the silicon wafer is measured by a pyrometer (radiation thermometer) installed outside of the chamber (see Patent Documents 1, 2, 3, 4, 5, for example).

A temperature of the silicon wafer is conventionally measured by a pyrometer through a component of a chamber window. The temperature measurement is taken at a single point in a central portion of an object to be measured, such as the silicon wafer. However, when heating the silicon wafer, a temperature distribution across the silicon wafer is not necessarily uniform. To achieve a desired temperature distribution, an output ratio of a heating unit is controlled for upper and lower portions of the silicon wafer, as well as for the central and peripheral portions. The ratio is adjusted based on quality results of the silicon wafer produced after the epitaxial growth process to meet the desired heating conditions.

According to the above adjustment of heating conditions, the output ratio of the heating unit is adjusted to reflect the quality results of the silicon wafer after the manufacturing process is completed. Therefore, setting different ratios according to the manufacturing stage is difficult, and generally, a fixed ratio is set throughout the manufacturing process.

### [Prior Art Documents]

### [Patent Documents]

Patent Document 1: Japanese Patent Application Publication No. 2009-507997
Patent Document 2: Japanese Patent Application Publication No. 2016-129162
Patent Document 3: Japanese Patent Application Publication No. 2018-44915
Patent Document 4: Japanese Patent Application Publication No. 2022-144083
Patent Document 5: Japanese Patent Application Publication No. H09-311081

### SUMMARY

In the above heating condition control, an optimal output ratio of the heating unit is considered to differ during a heating phase (where output is increased), a cooling phase (where output is decreased), and when the temperature is stable. However, no guideline has been available for obtaining the optimal output ratio of the heating unit, making it difficult to set the output ratio of the heating unit.

Consequently, in each step of the manufacturing process, adjustments to slow the heating and cooling rates were made to maintain a desired silicon wafer quality while keeping the output ratio of the heating unit constant. This is a factor hindering productivity. Further, since the output ratio of the heating unit was derived through trial and error, obtaining the optimal output ratio of the heating unit required considerable time.

The present invention addresses the aforementioned problems. An object of the present invention is to provide a temperature control apparatus, a temperature control method, and a temperature control program for an epitaxial growth apparatus for embodying a real-time adjustment of an output ratio of central and peripheral portions of a heating unit when heating the object to be measured, thereby setting optimal heating unit output conditions and achieving efficient production, and another object of the present invention is to provide a wafer manufacturing apparatus including the temperature control apparatus, which improves precision of temperature control during wafer manufacturing.

Specifically, a temperature control apparatus of the embodiment comprises: a chamber for housing an object to be measured; a plurality of heating units for heating the object to be measured through the chamber; a chamber window unit provided at a position in the chamber facing the object to be measured; a central temperature measurement unit positioned outside of the chamber window unit that measures a temperature at a central portion of the object to be measured through the chamber window unit; a peripheral temperature measurement unit positioned outside of the chamber window unit that measures a temperature at a peripheral portion of the object to be measured through the chamber window unit; an identification unit provided in the peripheral temperature measurement unit that identifies a position of the peripheral portion of the object to be measured within the chamber; an adjustment unit that adjusts the measurement direction of the peripheral temperature measurement unit based on identification results from the identification unit; a calculation unit that calculates the temperature of the central portion of the object to be measured from a detection value of the central temperature measurement unit and calculates the temperature of the peripheral portion of the object to be measured from the detection value of the peripheral temperature measurement unit; and an output control unit that controls outputs of the plurality of heating units based on both the central temperature and the peripheral temperature.

Further, a wafer manufacturing apparatus of the embodiment comprises: a chamber of an epitaxial growth apparatus that houses a silicon wafer internally; a plurality of heating units that heat the silicon wafer through the chamber; a chamber window unit provided at a position within the chamber facing the silicon wafer; a central temperature measurement unit positioned outside of the chamber window unit and measures a temperature of a central portion of the silicon wafer through the chamber window unit; a peripheral temperature measurement unit positioned outside of the chamber window and measures a temperature of a peripheral portion of the silicon wafer through the chamber window unit; an identification unit provided in the peripheral temperature measurement unit for identifying a position of the peripheral portion of the silicon wafer within the chamber; an adjustment unit that adjusts a measurement direction of the peripheral temperature measurement unit based on identification results from the identification unit; a calculation unit that calculates the temperature of the central portion of the silicon wafer from the detection value of the central temperature measurement unit, and that calculates the peripheral temperature of the silicon wafer from a detection value of the peripheral temperature measurement unit, and an output control unit that controls outputs of the plurality of heating units based on both the central temperature and the peripheral temperature.

According to the temperature control apparatus of the present invention, the temperature control apparatus comprises: a chamber for housing an object to be measured, a plurality of heating units for heating the object to be measured through the chamber, and a chamber window unit provided at a position of the chamber facing the object to be measured, and further comprises: a central temperature measurement unit positioned outside of the chamber window unit for measuring a temperature at a central portion of the object to be measured through the chamber window unit; and a peripheral temperature measurement unit positioned outside of the chamber window unit to measure a temperature of a peripheral portion of the object to be measured through the chamber window unit; an identification unit provided in the peripheral temperature measurement unit to identify a position of the peripheral portion of the object to be measured within the chamber; an adjustment unit that adjusts a measurement direction of the peripheral temperature measurement unit based on identification results from the identification unit; a calculation unit that calculates the temperature of the central portion of the object to be measured from a detection value of the central temperature measurement unit and calculates the temperature of the peripheral portion of the object to be measured from the detection value of the peripheral temperature measurement unit; and an output control unit that controls outputs of the plurality of heating units based on both the central temperature and the peripheral temperature. This enables the output ratio of the central and peripheral heating units to be changed at any time during heating of the object to be measured in an epitaxial growth apparatus, allowing optimal output conditions in the heating units to be set and efficient production of the object to be measured to be achieved. Further, by applying this to a wafer manufacturing apparatus, the heating conditions for the silicon wafer, which is an object to be measured, can be optimally controlled, enabling efficient production.

### BRIEF DESCRIPTION OF THE DRAWINGS

FIG. 1 is a schematic configuration diagram of a wafer manufacturing apparatus including a temperature control apparatus of the embodiment,
FIG. 2 is a schematic block diagram showing a configuration of a calculation unit of the temperature control apparatus,
FIG. 3A shows a first schematic diagram and FIG. 3B is a second schematic diagram of an object to be measured during temperature measurement,
FIG. 4A is a first schematic diagram illustrating identification conditions by an identification unit, and FIG. 4B is a second schematic diagram illustrating identification conditions by an identification unit, and
FIG. 5 is a flowchart showing processing steps in the temperature measurement apparatus of the embodiment.

### DETAILED DESCRIPTION OF EMBODIMENTS

The temperature control apparatus of the embodiment is primarily connected to a wafer manufacturing apparatus (specifically, an epitaxial apparatus or epitaxial growth apparatus) that manufactures wafers such as silicon wafers for semiconductors. The temperature control apparatus is used for measuring a temperature of the wafer during epitaxial growth and for controlling heating conditions.

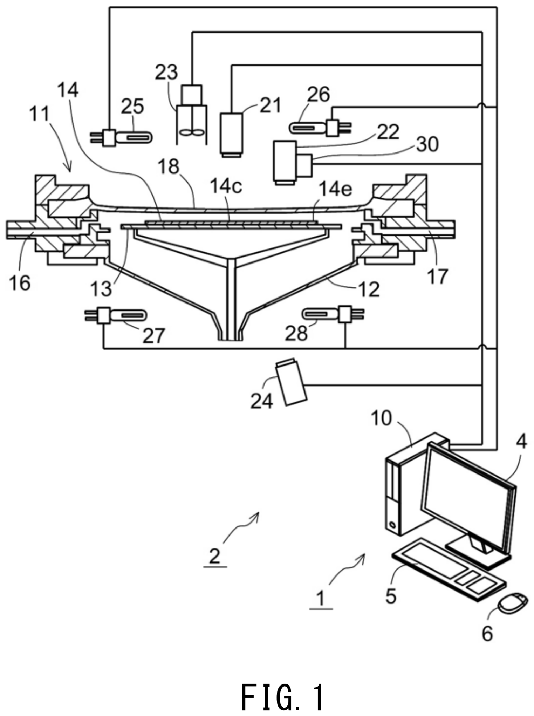

FIG. 1 is a schematic configuration diagram of a temperature control apparatus 1 of the embodiment and a wafer manufacturing apparatus 2 including the temperature control apparatus 1. Specifically, the wafer manufacturing apparatus 2 is an apparatus in which a chamber 11 of an epitaxial growth apparatus that performs epitaxial growth on silicon wafers and a computer 10 are combined. The number of the chambers 11 combined with the computer 10 may be one or a plurality as appropriate. For convenience, only one chamber 11 is shown in the figure.

The chamber 11 is an apparatus (furnace) that generates crystals on a surface of one or more silicon wafers 14 placed on a susceptor 13 with an appropriately shaped space. The gases necessary for crystal growth are introduced into the chamber 11 from a raw material gas tank (not shown) through a gas inlet 16. After undergoing a predetermined reaction, the gas is discharged outside of the chamber 11 through a gas outlet 17. A chamber window unit 18 made of quartz, which has excellent light transmittance, is installed in the chamber 11. The quartz chamber window unit 18 is positioned directly above the silicon wafer 14, which is the object to be measured, and faces the silicon wafer 14.

The chamber 11 houses the silicon wafer 14 therein. Heating units 25, 26, 27 and 28, which heat the silicon wafer 14 to a predetermined temperature, maintain that temperature, and cause the silicon wafer 14 to react with the gas, are installed at appropriate locations outside of the chamber 11. The heating units are heat sources that generate heat by energizing halogen lamps, infrared lamps, for example. The top surface of the silicon wafer 14 (the upper side in the figure) is heated by the heating units 25 and 26, while the bottom surface of the silicon wafer 14 (the lower side in the figure) is heated by the heating units 27 and 28. Further, the central portion of the silicon wafer 14 is heated by the heating units 26 and 28, while the peripheral portion of the silicon wafer 14 is heated by the heating units 25 and 27. Since a plurality of heating units are installed at different positions, heating corresponding to specific areas of the silicon wafer 14 is possible.

A plurality of temperature measurement units (shown as three locations) are provided to measure the temperature of the silicon wafer 14 (the object to be measured or processed) placed on the susceptor 13 within the chamber 11. The central temperature measurement unit 21 (first temperature measurement unit) is a temperature measurement unit positioned outside of the chamber window unit 18, vertically above the central portion 14c of the silicon wafer 14 through the chamber window unit 18, and measures the temperature of the central portion 14c of the silicon wafer 14. The peripheral temperature measurement unit 22 (second temperature measurement unit) is a temperature measurement unit positioned outside of the chamber window unit 18 and configured to measure the temperature of the peripheral portion 14e of the silicon wafer 14 through the chamber window unit 18. Of course, the number of central temperature measurement units 21 and the peripheral temperature measurement units 22 is not limited to a single unit shown in the figure; a plurality of units (not shown) may also be installed.

Further, a susceptor temperature measurement unit 24 (third temperature measurement unit) for measuring a temperature of the susceptor 13 inside the chamber 11 is installed at an appropriate location on the bottom 12 of the chamber 11. The central temperature measurement unit 21, the peripheral temperature measurement unit 22, and the susceptor temperature measurement unit 24 are noncontact temperature sensors, such as pyrometers, which measure the radiant power (radiated heat, emissivity) of an object based on Stefan-Boltzmann's law and Planck's law. Further, a temperature control unit 23 is provided to cool the chamber 11 after heating by the heating unit 25, for example, thereby suppressing excessive heating within the chamber window unit 18. The temperature control unit 23 is an apparatus such as a blower that blows air onto the surface of the chamber 11.

The peripheral temperature measurement unit 22 includes an identification unit 30. The identification unit 30 is an apparatus that identifies a position of the peripheral portion 14e of the silicon wafer 14 within the chamber 11 while the silicon wafer 14 is being heated. By identifying the peripheral portion 14e of the silicon wafer 14, the identification unit 30 confirms whether the measurement direction of the peripheral temperature measurement unit 22 is appropriate. Further, an adjustment unit 110 is provided to adjust the measurement direction of the peripheral temperature measurement unit 22 based on identification results from the identification unit 30. The measurement direction of the peripheral temperature measurement unit 22 is, obviously, inside the peripheral portion 14e of the silicon wafer 14. The identification unit 30 and the peripheral temperature measurement unit 22 are supported in a swingable manner above the chamber 11 in the wafer manufacturing apparatus 2 including the temperature control apparatus 1. Therefore, the peripheral temperature measurement unit 22 changes (swings) the necessary amount of angle at a shaft portion (not shown) supporting the peripheral temperature measurement unit 22 in accordance with a rotation of the silicon wafer 14 on the susceptor 13.

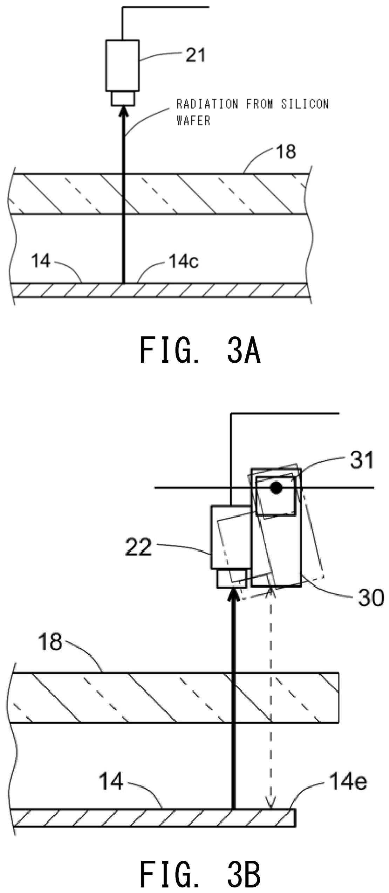

The identification unit 30 is an identifying apparatus, such as a laser pointer. A laser is irradiated from the identification unit 30 toward the peripheral portion 14e of the target silicon wafer 14, and reflected light from the target silicon wafer 14 is received. Based on changes in an amount of the received light, it is confirmed whether the measurement direction of the peripheral temperature measurement unit 22 is facing the peripheral portion 14e of the silicon wafer 14. The identification unit 30 includes a drive mechanism 31 (see FIG. 3), such as a servo motor. Based on the results from the identification unit 30 and the control of the computer 10 (an adjustment unit 110 described later), the drive mechanism 31 operates to correct the angle of the peripheral temperature measurement unit 22 so that the measurement direction of the peripheral temperature measurement unit 22 faces the peripheral portion 14e of the silicon wafer 14.

As shown in the schematic diagram of FIG. 3, when the central temperature measurement unit 21 and the peripheral temperature measurement unit 22, such as pyrometers, are used to measure the temperature of the silicon wafer 14, which is the object to be measured, from outside of the chamber 11, the radiant intensity actually measured by the central temperature measurement unit 21 includes both the radiant intensity of the silicon wafer 14 and the radiant intensity originating from the chamber window unit 18 constituting the chamber 11. The detection value is combined radiant intensity of both of the radiant intensity of the silicon wafer 14 and the radiant intensity originating from the chamber window unit 18. Here, the chamber window unit 18 is made of quartz and has a uniform material composition. Based on the heating conditions applied to the silicon wafer 14 to be measured, it is possible to calculate the radiant intensity attributable to the quartz chamber window unit 18. Therefore, the total radiant intensity is first calculated via the central temperature measurement unit 21. Subsequently, the influence of the radiant intensity attributable to the quartz chamber window unit 18 is excluded using conversion data, ultimately enabling the temperature measurement of the silicon wafer 14 to be measured.

As shown in FIG. 3A, the central temperature measurement unit 21 is positioned directly above the central portion 14c of the silicon wafer 14, separated by the chamber window unit 18. Since the central portion 14c of the silicon wafer 14 does not significantly shift on the susceptor 13, the central temperature measurement unit 21 is installed in a fixed position.

In FIG. 3B, the peripheral temperature measurement unit 22 is installed at the position of the peripheral portion 14e of the silicon wafer 14, with the chamber window unit 18 in between. As described above, the peripheral temperature measurement unit 22 includes the identification unit 30. The drive mechanism 31 (e.g., a servo motor) of the identification unit 30 appropriately changes and controls the measurement direction of the peripheral temperature measuring unit 22, i.e., an angle (see a solid line and a double-dotted line in the figure).

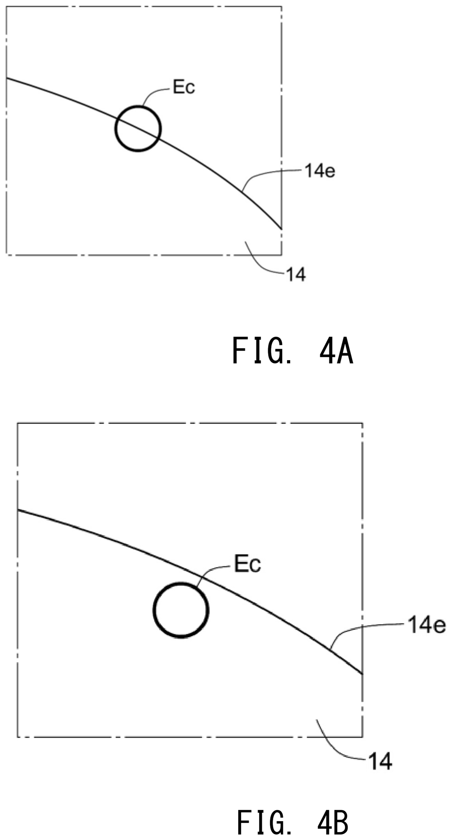

The schematic diagram in FIG. 4 shows the identification unit 30 as the laser pointer and the peripheral portion 14e of the silicon wafer 14. The thick solid line represents an edge of the silicon wafer 14, indicating the peripheral portion 14e. A circle Ec in the figure indicates the measurement area of the peripheral temperature measurement unit 22, which is a range of a laser beam irradiated from the laser pointer of the identification unit 30 onto the peripheral portion 14e of the target silicon wafer 14. A camera is mounted on the identification unit 30 of the laser pointer to capture the reflected light from the silicon wafer 14.

In FIG. 4A, the circle Ec representing a range of the irradiated laser extends beyond the peripheral portion 14e, and thus the temperatures of regions other than the silicon wafer 14 may be measured, thereby reducing the accuracy of the temperature measurement.

In FIG. 4B, the circle Ec representing the range of the laser beam irradiated from the laser pointer of the identification unit 30 onto the peripheral portion 14e of the target silicon wafer 14 is positioned further inward relative to the peripheral portion 14e compared to FIG. 4A. Consequently, the circle Ec is positioned inside the peripheral portion 14e, that is, the target area to be measured is confined within the peripheral portion 14e. Therefore, the temperature of the peripheral portion 14e of the silicon wafer 14 can be accurately measured by the peripheral temperature measurement unit 22.

The silicon wafer 14 on the susceptor 13 within the chamber 11 is not necessarily positioned aligned with the rotation axis of the susceptor 13 (centered). Accordingly, during rotation of the susceptor 13 for epitaxial growth, the silicon wafer 14 may shift out of the measurement direction of the peripheral temperature measurement unit 22. Therefore, the identification unit 30 and the adjustment unit 110 are provided. This enables tracking of the measurement direction of the peripheral temperature measurement unit 22 relative to the peripheral portion 14e of the silicon wafer 14, thereby achieving accurate temperature measurement of the peripheral portion 14e of the silicon wafer 14.

Regarding the coordination between the aforementioned identification unit 30 and the adjustment unit 110 described later, for example, the silicon wafer 14, which is an object to be measured, is pre-placed at a predetermined position inside the chamber 11. A laser is irradiated onto the peripheral region 14e of the target silicon wafer 14 from the identification unit 30, and the measurement direction of the peripheral temperature measurement unit 22 is adjusted. The adjustment method may be either control by a computer 10 described later or offline control. Additionally, a scale or gauge for adjusting the position and angle may be attached to the peripheral temperature measurement unit 22. The results of the prior laser irradiation from the identification unit 30 onto the peripheral portion 14e of the silicon wafer 14 are stored. The peripheral temperature measurement unit 22 is then set to the position and angle corresponding to these stored results. This allows the sequential laser irradiation from the identification unit 30 to be omitted each time.

In the wafer manufacturing apparatus 2, the central temperature measurement unit 21, the peripheral temperature measurement unit 22, the susceptor temperature measurement unit 24, the temperature control unit 23, the heating units 25, 26, 27 and 28, the identification unit 30, for example, are connected to the computer 10, and signal transmission occurs between them and the computer 10. Note that wiring for power supply to each of the temperature measurement units 21, 22 and 24, the temperature control unit 23, and the heating units 25, 26, 27 and 28 is omitted from illustration.

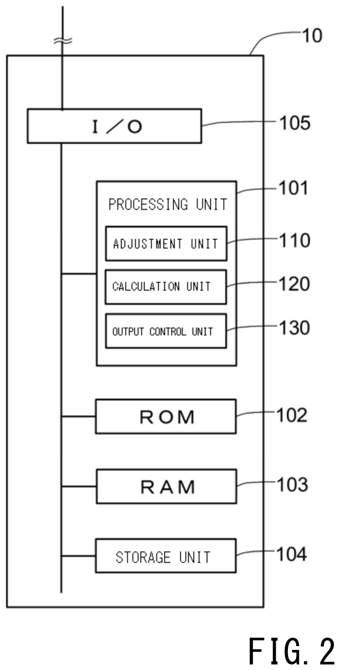

The temperature control apparatus 1 includes a known computer 10 capable of performing calculations, as the temperature control apparatus 1 calculates the temperature of the silicon wafer 14 or other object to be measured based on the detection values from the central temperature measurement unit 21, the peripheral temperature measurement unit 22, and the susceptor temperature measurement unit 24. As shown in the block diagram of FIG. 2, the computer 10 is implemented with hardware components including a processing unit 101 (CPU, GPU, for example), a ROM 102, a RAM 103, a storage unit 104, for example, and appropriately including an I/O (input-output interface) 105, for example. The computer 10 is configured using various electronic computers (computing resources), such as known personal computers, supercomputers, mainframes, workstations, and cloud computing systems.

Additionally, as shown in FIG. 1, the computer 10 includes an output display (monitor) 4, an input keyboard 5, and a mouse 6. These are connected to the I/O 105. The central temperature measurement unit 21, the peripheral temperature measurement unit 22, the susceptor temperature measurement unit 24, the temperature control unit 23, and the heating units 25, 26, 27 and 28 disclosed in FIG. 1 are connected to the I/O 105.

When implementing the functional units of the computer 10 of the temperature control apparatus 1 via software, the computer 10 implements these functions by executing instructions from a program, which is the software embodying each function. The recording medium storing this program can be a "non-transitory tangible medium", such as a CD, DVD, semiconductor memory, or programmable logic circuit. Further, this program may be supplied to the computer 10 of the temperature control apparatus 1 via any transmission medium capable of transmitting the program (e.g., communication networks, broadcast waves, for example).

The storage unit 104 of the computer 10 in the temperature control apparatus 1 may include a storage device such as an HDD or SSD. Alternatively, the storage unit 104 may be an external server (not shown). The storage unit 104 stores various data, information, programs, and various data necessary for executing the programs.

The functional units implemented by the processing unit 101 of the computer 10 of the temperature control apparatus 1 are shown as per the schematic block diagram in FIG. 2. The functional units include an adjustment unit 110, a calculation unit 120, and an output control unit 130. An output unit is also provided to execute the processing required for output. The processing and execution in the temperature control apparatus 1 and the wafer manufacturing apparatus 2 are embodied software-wise by temperature measurement programs, for example, loaded into a main memory.

The adjustment unit 110 adjusts the measurement direction of the peripheral temperature measurement unit 22 based on identification results from the identification unit 30. If the measurement direction of the peripheral temperature measurement unit 22 remains unchanged based on the identification results from the identification unit 30, the adjustment unit 110 performs no special control. If the adjustment unit 110 determines from the identification result that the measurement direction of the peripheral temperature measurement unit 22 requires calibration, the adjustment unit 110 generates information regarding the amount of operation (motor rotation amount) of the drive mechanism 31, such as a servo motor, provided in the identification unit 30. The adjustment unit 110 then transmits a control signal to the identification unit 30, which is driven based on the amount of operation corresponding to the control signal. As a result, the measurement direction of the peripheral temperature measurement unit 22 is adjusted to face the peripheral portion 14e of the silicon wafer 14. Reference is made to the descriptions of FIGS. 3 and 4 above. Specifically, within the image captured by the identification unit 30, the peripheral portion 14e of the silicon wafer 14 is identified. The circle Ec (the measurement area of the peripheral temperature measurement unit 22) in FIG. 4 is adjusted to be positioned within the arc of the peripheral portion 14e, at a predetermined distance from the edge.

The operation and processing of the adjustment unit 110 can be broadly categorized into the following two types. The first type is a preset mode, as described above, where the measurement direction of the peripheral temperature measurement unit 22 is adjusted based on laser irradiation from the identification unit 30 toward the peripheral portion 14e of the target silicon wafer 14. In this first type, the positioning each time of the peripheral temperature measurement unit 22 is omitted, simplifying the overall process. The second type is a mode where, during processing (the epitaxial growth process) of the silicon wafer 14 on the susceptor 13 inside the chamber 11, the position and angle of the peripheral temperature measurement unit 22 are sequentially corrected relative to the silicon wafer 14. In this second type, precise alignment of the peripheral temperature measurement unit 22 is performed even during the process, resulting in more accurate temperature measurement of the silicon wafer 14.

The calculation unit 120 calculates the central temperature (Tc) of the silicon wafer 14 (the temperature near the central portion 14c) from the detection value of the central temperature measurement unit 21. Simultaneously, the calculation unit 120 calculates the peripheral temperature (Tp) of the silicon wafer 14 (the temperature near the peripheral portion 14e) from the detection value of the peripheral temperature measurement unit 22. More specifically, the calculation unit 120 estimates the target temperature change amount of the silicon wafer 14 by excluding the influence of the radiant intensity attribute to the chamber window unit from the measured temperature change amount calculated from the detection values of each temperature measurement unit. Then, the calculation unit 120 generates conversion data based on the correlation between the measured temperature change amount and the target temperature change amount.

The measured temperature change amount calculated from the detection values of the temperature measurement units, such as the central temperature measurement unit 21 and the peripheral temperature measurement unit 22, is a measurement of a so-called apparent temperature change. However, it is self-evident that this does not necessarily correspond to the actual temperature of the silicon wafer 14 inside the chamber 11. Specifically, since components of the chamber window unit 18 are positioned between the central temperature measurement unit 21, the peripheral temperature measurement unit 22, and the silicon wafer 14, the influence of radiant heat from the components of the chamber window unit 18 is unavoidable. Strictly speaking, a discrepancy exists between the actual measured temperature during heating and the temperature of the silicon wafer 14. The calculation unit 120 may generate conversion data to correct (calibrate) for such temperature discrepancies.

The output control unit 130 controls the output of the heating units 25, 26, 27 and 28 based on both the central temperature (Tc) and the peripheral temperature (Tp). Since the heating units are heat sources such as halogen lamps, output control involves increasing or decreasing the electrical power supplied to each heating unit. In the temperature control apparatus 1 and the wafer manufacturing apparatus 2 of the embodiment, the outputs of the heating units 25, 26, 27 and 28 are each controlled independently.

The output control performed by the output control unit 130 may be implemented as feedback control based on both the central temperature (Tc) and the peripheral temperature (Tp). Since the temperature control of the heating units 25, 26, 27 and 28 can be performed reflecting the central temperature (Tc) and the peripheral temperature (Tp) obtained from the measured values (corrected), responsiveness is improved. Further, temperature control via output control of the heating units 25, 26, 27 and 28 may be performed by considering the measured values (corrected) from the susceptor temperature measurement unit 24.

Further, the output control unit 130 can perform a feedback control using either the central temperature (Tc) or the peripheral temperature (Tp) instead of both the central temperature (Tc) and the peripheral temperature (Tp), thereby controlling the output of the heating units 25, 26, 27 and 28. If the measurement result of either the central temperature (Tc) or the peripheral temperature (Tp) can substitute for the other result (i.e., convertible), then only one of them may be adopted instead of both.

In the feedback control using both the central temperature (Tc) and the peripheral temperature (Tp), the heating units corresponding to the central temperature (Tc) and the peripheral temperature (Tp) are independently temperature-controlled based on their respective measured values. Alternatively, the heating units for the portions corresponding to the central temperature (Tc) and the peripheral temperature (Tp) can be temperature-controlled to maintain a constant temperature difference (ΔT = Tc - Tp) between the central temperature (Tc) and the peripheral temperature (Tp).

Further, in the feedback control from both the central temperature (Tc) and the peripheral temperature (Tp), the ratio of output values (watts) between a plurality of heating units corresponding to the central temperature (Tc) and the peripheral temperature (Tp) may be controlled to be maintained at a constant condition based on each measured value.

As shown in FIG. 1, the central portion of the silicon wafer 14 is heated by the heating units 26 and 28, while the peripheral portion of the silicon wafer 14 is heated by the heating units 25 and 27. For example, the output ratio (Pu = Pup/Puc) between the output (Puc) of the heating unit 26 and the output (Pup) of the heating unit 25 on the upper surface of the silicon wafer 14 is specified. Naturally, the same applies to the bottom surface of the silicon wafer 14 (the output ratio between heating units 28 and 27). Additionally, the output ratio between the upper and lower heating units on the central side of the silicon wafer 14 (shown as the output ratio between the heating units 26 and 25 in the figure) and the output ratio between the upper and lower heating units on the peripheral portion of the silicon wafer 14 (shown as the output ratio between the heating units 27 and 28 in the figure) can be specified.

In the epitaxial growth reaction on the silicon wafer 14, the relative positions of the heating units 25, 26, 27 and 28 mean that the central temperature (Tc) and the peripheral temperature (Tp) need not be completely identical at all times. A temperature difference (ΔT) is permissible as long as the temperature difference (ΔT) does not cause manufacturing problems. Therefore, the temperature difference (ΔT) between the central temperature (Tc) and the peripheral temperature (Tp) is monitored. Temperature control is achieved by maintaining this temperature difference (ΔT) through output control of the individual heating units 25, 26, 27 and 28. Specifically, the epitaxial growth reaction involves heating, temperature maintenance, and cooling processes. Accordingly, during these temperature-changing processes, maintaining the temperature difference (ΔT) between the central temperature (Tc) and the peripheral temperature (Tp) ensures stable quality in the epitaxial growth of the silicon wafer 14.

Further, since the output ratio between heating units can be individually set, direct heating control of the silicon wafer 14 through the heating units becomes possible. Consequently, the direct heating control is suitable for control when heating and cooling are required while maintaining the output ratio between the heating units.

Thresholds are set for the temperature difference (ΔT) between the central temperature (Tc) and the peripheral temperature (Tp), and for the output ratio (Pu, for example) between the heating units on the central and peripheral portions of the same surface of the silicon wafer 14, or between heating units on the top and bottom of the silicon wafer 14. In the production of epitaxial growth on silicon wafers 14, variations in equipment, measurement errors, and fluctuations in manufacturing conditions are unavoidable. Therefore, variations in the temperature difference and the output ratio within ranges that do not cause manufacturing problems are permitted. However, from a quality assurance perspective, thresholds (values with a range of lower and upper limits) are set as the permissible limits. When a state deviating from the threshold occurs, the silicon wafer 14 being manufactured at that time may be discarded as defective. Alternatively, limits may be set as control values, and manufacturing may continue.

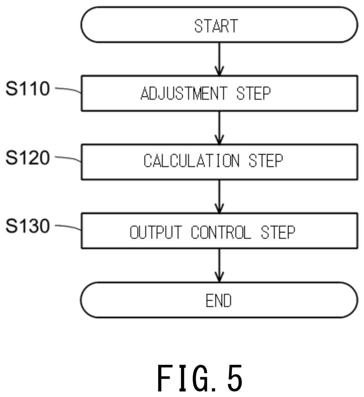

Using the flowchart in FIG. 5, the temperature control program in the computer 10 (processing unit 101) of the temperature control apparatus 1 and the wafer manufacturing apparatus 2 of the embodiment is described. The temperature control method is executed by the processing unit 101 (computing element) of the computer 10 based on the temperature control program.

The temperature control program causes the computer 10 shown in FIG. 2 to execute adjustment functions, calculation functions, output control functions, for example. Although omitted from the description, functions necessary for the apparatus, such as output functions, are naturally included and executed. Details of each function are omitted as they overlap with the previous description of the temperature control apparatus 1.

As shown in the flowchart of FIG. 5, the processing of the processing unit 101 included in the computer 10 (processing element) comprises various steps: an adjustment step (S110), a calculation step (S120), and an output control step (S130). Naturally, various steps necessary for the operation of the computer 10 itself are also included.

By the adjustment function, the measurement direction of the peripheral temperature measurement unit 22 is adjusted based on (following) the identification result of the identification unit 30 (S110; adjustment step). By the calculation function, the central temperature of the silicon wafer 14, which is the object to be measured is calculated, from the detection value of the central temperature measurement unit 21, and the peripheral temperature of the same silicon wafer 14 is calculated from the detection value of the peripheral temperature measurement unit 22 (S120; calculation step). By the output control function, the output of the heating units 25, 26, 27 and 28 is controlled based on both the central temperature and the peripheral temperature.

The computer program of the present invention described above may be recorded on a processor-readable recording medium. As the recording medium, a "non-transitory tangible medium" may be used, such as a disk, card, semiconductor memory, or programmable logic circuit.

The above computer program may be implemented using, for example, scripting languages such as ActionScript or JavaScript (registered trademark), object-oriented programming languages such as Objective-C or Java (registered trademark), or markup languages such as HTML5.

## Claims

1. A temperature control apparatus (1) for an epitaxial growth apparatus, the epitaxial growth apparatus comprising:
a chamber (11) for housing an object to be measured;
a plurality of heating units (25, 26, 27, 28) for heating the object to be measured through the chamber (11); and
a chamber window unit (18) provided at a position of the chamber (11) facing the object to be measured,
the temperature control apparatus (1) comprising:
a central temperature measurement unit (21) positioned outside of the chamber window unit (18) and measures a temperature at a central portion (14c) of the object to be measured through the chamber window unit (18);
a peripheral temperature measurement unit (22) positioned outside of the chamber window unit (18) and measures a temperature of a peripheral portion (14e) of the object to be measured through the chamber window unit (18);
an identification unit (30) provided in the peripheral temperature measurement unit (22) to identify a position of the peripheral portion (14e) of the object to be measured within the chamber (11);
an adjustment unit (110) that adjusts a measurement direction of the peripheral temperature measurement unit (22) based on identification results from the identification unit (30);
a calculation unit (120) that calculates the temperature of the central portion (14c) of the object to be measured based on a detection value from the central temperature measurement unit (21) and calculates the temperature of the peripheral portion (14e) of the object to be measured based on the detection value from the peripheral temperature measurement unit (22); and
an output control unit (130) that controls the output of the plurality of heating units (25, 26, 27, 28) based on both the central temperature and the peripheral temperature.

2. The temperature control apparatus (1) according to claim 1, wherein a laser pointer is provided at the identification unit (30), and the position of the peripheral portion (14e) is identified based on laser light irradiated by the laser pointer.

3. The temperature control apparatus (1) according to claim 1, wherein the plurality of heating units (25, 26, 27, 28) are installed in plural numbers at upper and lower portions of the chamber (11), respectively, to heat the object to be measured from above and below.

4. The temperature control apparatus (1) according to claim 1, wherein the output control unit (130) controls outputs of the plurality of heating units (25, 26, 27, 28) by a feedback control based on at least one of the central temperature and the peripheral temperature.

5. The temperature control apparatus (1) according to claim 4, wherein the output control unit (130) controls the outputs of the plurality of heating units (25, 26, 27, 28) to the central portion (14c) and the peripheral portion (14e) of the object to be measured by feedback controlling a temperature difference between the central temperature and the peripheral temperature.

6. The temperature control apparatus (1) according to claim 5, wherein the temperature difference between the central temperature and the peripheral temperature is set within a predetermined threshold range.

7. The temperature control apparatus (1) according to claim 3, wherein the output control unit (130) controls an output ratio between heating units (25, 26, 27, 28) of the portions of the object to be measured corresponding to the central temperature and the peripheral temperature based on the central temperature and the peripheral temperature.

8. The temperature control apparatus (1) according to claim 7, wherein the output ratio is set within a predetermined threshold range.

9. The temperature control apparatus (1) according to claim 1, wherein the object to be measured is a silicon wafer (14).

10. The temperature control apparatus (1) according to claim 1, wherein the identification unit (30) is provided in the peripheral temperature measurement unit (22) and identifies the position of the peripheral portion (14e) of the object to be measured while the object is being heated inside the chamber (11),
wherein the adjustment unit (110) adjusts a measurement direction of the peripheral temperature measurement unit (22) following the identification results of the identification unit (30).

11. A temperature control method in a temperature control apparatus (1) for an epitaxial growth apparatus including:
a chamber (11) for housing an object to be measured;
a plurality of heating units (25, 26, 27, 28) that heat an object to be measured through the chamber (11);
a chamber window unit (18) provided at a position of the chamber (11) facing the object to be measured;
a central temperature measurement unit (21) positioned outside of the chamber window unit (18) and measures a temperature at a central portion (14c) of the object to be measured through the chamber window unit (18);
a peripheral temperature measurement unit (22) positioned outside of the chamber window unit (18) and measures a temperature of a peripheral portion (14e) of the object to be measured through the chamber window unit (18);
an identification unit (30) provided in the peripheral temperature measurement unit (22) to identify a position of the peripheral portion (14e) of the object to be measured within the chamber (11),
wherein the temperature control method comprises the steps of:
adjusting a measurement direction of the peripheral temperature measurement unit (22) based on identification results of the identification unit (30);
calculating the central temperature of the object to be measured from a detection value of the central temperature measurement unit (21) and calculating the peripheral temperature of the object to be measured from the detection value of the peripheral temperature measurement unit (22); and
controlling outputs of the plurality of heating units (25, 26, 27, 28) based on both the central temperature and the peripheral temperature.

12. A temperature control program for a temperature control apparatus (1) of an epitaxial growth apparatus comprising:
a chamber (11) for housing an object to be measured;
a plurality of heating units (25, 26, 27, 28) that heat the object to be measured through the chamber (11);
a chamber window unit (18) provided at a position of the chamber (11) facing the object to be measured;
a central temperature measurement unit (21) positioned outside of the chamber window unit (18) and measures a temperature at a central portion (14c) of the object to be measured through the chamber window unit (18);
a peripheral temperature measurement unit (22) positioned outside of the chamber window unit (18) and measures the temperature of the peripheral portion of the object to be measured through the chamber window unit (18);
an identification unit (30) provided in the peripheral temperature measurement unit (22) to identify a position of the peripheral portion (14e) of the object to be measured within the chamber (11),
the temperature control apparatus (1) embodies functions of:
adjusting a measurement direction of the peripheral temperature measurement unit (22) based on identification results from the identification unit (30);
calculating the central temperature of the object to be measured from a detection value of the central temperature measurement unit (21) and calculating the peripheral temperature of the object to be measured from the detection value of the peripheral temperature measurement unit (22); and
controlling outputs of the plurality of heating units (25, 26, 27, 28) based on both the central temperature and the peripheral temperature.

13. A wafer manufacturing apparatus (2) comprising:
a chamber (11) of an epitaxial growth apparatus that houses a silicon wafer (14) internally;
a plurality of heating units (25, 26, 27, 28) that heat the silicon wafer (14) through the chamber (11);
a chamber window unit (18) provided at a position of the chamber (11) facing the silicon wafer (14);
a central temperature measurement unit (21) positioned outside of the chamber window unit (18) and measures a temperature at a central portion (14c) of the silicon wafer (14) through the chamber window unit (18);
a peripheral temperature measurement unit (22) positioned outside of the chamber window unit (18) and measures a temperature of a peripheral portion (14e) of the silicon wafer (14) through the chamber window unit (18);
an identification unit (30) provided in the peripheral temperature measurement unit (22) to identify the position of the peripheral portion (14e) of the silicon wafer (14) within the chamber (11);
an adjustment unit (110) that adjusts a measurement direction of the peripheral temperature measurement unit (22) based on identification results from the identification unit (30);
a calculation unit (120) that calculates the temperature of the central portion (14c) of the silicon wafer (14) from the detection value of the central temperature measurement unit (21) and calculates the temperature of the peripheral portion (14e) of the silicon wafer (14) from a detection value of the peripheral temperature measurement unit (22);
an output control unit (130) that controls outputs of the plurality of heating units (25, 26, 27, 28) based on both the central temperature and the peripheral temperature.

14. The wafer manufacturing apparatus (2) according to claim 13, wherein a laser pointer is provided at the identification unit (30), and the position of the peripheral portion (14e) is identified based on laser light irradiated by the laser pointer.

15. The wafer manufacturing apparatus (2) according to claim 13, wherein the plurality of heating units (25, 26, 27, 28) are installed in plural numbers at the top and bottom of the chamber (11), respectively, to heat the silicon wafer (14) from above and below.

16. The wafer manufacturing apparatus (2) according to claim 13, wherein the identification unit (30) is provided in the peripheral temperature measurement unit (22) and identifies the position of the peripheral portion (14e) of the object to be measured while the silicon wafer (14) is being heated inside the chamber (11),
wherein the adjustment unit (110) adjusts the measurement direction of the peripheral temperature measurement unit (22) based on the identification results from the identification unit (30).
